(19) Europäisches Patentamt / European Patent Office / Office européen des brevets

(11) **EP 2 926 152 B1**

(12) **EUROPÄISCHE PATENTSCHRIFT**

(45) Veröffentlichungstag und Bekanntmachung des Hinweises auf die Patenterteilung:
**07.11.2018   Patentblatt 2018/45**

(21) Anmeldenummer: **13771386.3**

(22) Anmeldetag: **25.09.2013**

(51) Int Cl.:
***G01R 31/08*** *(2006.01)*

(86) Internationale Anmeldenummer:
**PCT/EP2013/002874**

(87) Internationale Veröffentlichungsnummer:
**WO 2014/082690 (05.06.2014 Gazette 2014/23)**

(54) **VERFAHREN ZUM ORTEN VON FEHLERHAFTEN STELLEN IN EINEM HF-SIGNALÜBERTRAGUNGSPFAD**

METHOD FOR LOCATING DEFECTIVE POINTS IN A HF SIGNAL TRANSMISSION PATH

PROCÉDÉ DE LOCALISATION DE POINTS DÉFECTUEUX DANS UNE VOIE DE TRANSMISSION DE SIGNAUX HF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.11.2012   DE 102012023448**

(43) Veröffentlichungstag der Anmeldung:
**07.10.2015   Patentblatt 2015/41**

(73) Patentinhaber: **Rosenberger Hochfrequenztechnik GmH & Co. KG**
**83413 Fridolfing (DE)**

(72) Erfinder:
• **ENTSFELLNER, Christian**
  **83143 Fridolfing (DE)**
• **KAINDL, Benjamin**
  **83413 Fridolfing (DE)**

(74) Vertreter: **Zeitler Volpert Kandlbinder Patent- und Rechtsanwälte Partnerschaft mbB Postfach 26 02 51 80059 München (DE)**

(56) Entgegenhaltungen:
WO-A1-01/02810          WO-A1-2006/032854
WO-A2-03/027691         WO-A2-2010/001139
DE-A1-102010 015 102

EP 2 926 152 B1

**Beschreibung**

Die vorliegende Erfindung betrifft ein Verfahren zum Orten von Stellen in einem Signalübertragungspfad für ein Hochfrequenzsignal, wobei diese Stellen im Sinne von Hochfrequenzübertragungseigenschaften des Signalübertragungspfades fehlerhaft sind.

Bei einem Signalübertragungspfad für HF-Signale, beispielsweise bei einer Mobilfunkbasisstation, wobei der Signalübertragungspfad beispielsweise HF-Leitungskabel, HF-Steckverbinder, einen Blitzschutz und/oder eine Antenne zum Abstrahlen des HF-Signals umfasst, ergeben Messungen der HF-Übertragungseigenschaften oftmals eine verminderte Übertragungsfähigkeit, welche sich zu hohen Frequenzen hin mehr verschlechtert, als dies rechnerisch der Fall sein dürfte oder als aufgrund der HF-Übertragungseigenschaften der Einzelkomponenten zu erwarten ist. Hierdurch ergibt sich eine aufwändige Fehlersuche in dem Gesamtsystem des Signalübertragungspfades nach fehlerhaften Stellen, an denen beispielsweise ein HF-Stecker nicht vollständig geschlossen oder fehlerhaft montiert ist oder ein Kabelbruch in einem HF-Leitungskabel vorliegt, wodurch sich an dieser Stelle eine nichtlineare Übertragungsfunktion für HF-Signale ergibt, die zur Verminderung der HF-Signalübertragungseigenschaften des Gesamtsystems des Signalübertragungspfades führt.

Die Druckschrift DE 10 2010 015 102 A1 beschreibt ein Verfahren zum Orten von Stellen in einem Signalübertragungspfad für ein Hochfrequenzsignal, wobei diese Stellen im Sinne von Hochfrequenzübertragungseigenschaften des Signalübertragungspfads fehlerhaft sind. Dabei werden zwei Signale unterschiedlicher Frequenz in den Signalübertragungspfad eingeleitet und eine Zeitspanne gemessen, bis am Einleitungszeitpunkt der beiden Signale ein Intermodulationsprodukt ankommt. Eines der beiden Signale wird dabei über einen vorbestimmten Bereich periodisch gesweept. Es wird eine Entfernung der fehlerhaften Stelle von dem Einleitungspunkt bestimmt.

Die Druckschrift WO 03/027691 A1 beschreibt ein Verfahren zum Lokalisieren einer Störung einer Leitung, bei dem ein in einer ersten Ausbreitungsrichtung propagierendes erstes Signal und ein in einer anderen Ausbreitungsrichtung propagierendes zweites Signal zur Bestimmung einer Position der Störung in der Leitung ausgewertet werden.

Der Erfindung liegt die Aufgabe zugrunde, ein Verfahren der o.g. Art derart auszugestalten, dass in HF-technischer Sicht fehlerhafte Stellen in einem Signalübertragungspfad auf einfache Weise und gleichzeitig örtlich sehr genau lokalisiert werden können, so dass die Fehlersuche vereinfacht wird.

Diese Aufgabe wird erfindungsgemäß durch ein Verfahren der o.g. Art mit den in Anspruch 1 angegebenen Verfahrensschritten gelöst. Vorteilhafte Ausgestaltungen der Erfindung sind in den weiteren Ansprüchen beschrieben.

Bei einem Verfahren der o.g. Art sind erfindungsgemäß folgende Verfahrensschritte vorgesehen:

(a) Erzeugen eines ersten HF-Signals mit einer konstanten vorbestimmten Frequenz $f_1$ sowie einem mit einer vorbestimmten Modulationsart aufmodulierten Signal, wobei die Modulationsart eine Amplitudenmodulation oder eine digitale Modulation ist und/oder wobei das aufmodulierte Signal ein Rauschen ist, insbesondere ein Quasirauschen oder Pseudo-Noise;

(b) Erzeugen eines zweiten HF-Signals mit einer konstanten vorbestimmten Frequenz $f_2$;

(c) Erzeugen eines vorbestimmten Intermodulationsproduktes in Form eines Intermodulationsprodukt-Signals mit der Frequenz $f_{IM-ERZEUGT}$ aus dem ersten und dem zweiten HF-Signal,

(d) Einleiten des ersten HF-Signals und des zweiten HF-Signals in den Signalübertragungspfad an einem vorbestimmten Einleitungspunkt;

(e) Empfangen eines in dem Signalübertragungspfad aus dem ersten HF-Signal und dem zweiten HF-Signal an einer fehlerhaften Stelle erzeugten und zum Einleitungspunkt zurück reflektierten Intermodulationsproduktes, welches dem in Schritt (c) erzeugten Intermodulationsprodukt entspricht, in Form eines Intermodulationsprodukt-Signals mit der Frequenz $f_{IM-EMPFANGEN}$, am vorbestimmten Einleitungspunkt;

(f) Bestimmen einer Zeitverschiebung $t_x$ zwischen dem erzeugten Intermodulationsprodukt-Signal $f_{IM-ERZEUGT}$ und dem empfangenen Intermodulationsprodukt-Signal $f_{IM-EMPFANGEN}$ mittels einer Kreuzkorrelation und

(g) Berechnen einer Länge L zwischen dem Einleitungspunkt und der Stelle in dem Signalübertragungspfad, von der aus das in Schritt (e) empfangene Signal reflektiert wurde, aus der in Schritt (f) bestimmten Zeitverschiebung $t_x$.

Dies hat den Vorteil, dass unter Ausnutzung von an fehlerhaften Stellen des Signalübertragungspfades erzeugten Intermodulationsprodukten derartige Stellen örtlich sehr genau lokalisiert werden können, ohne hierzu den Signalübertragungspfad mechanisch bearbeiten, insbesondere zerlegen oder zerstören, zu müssen. Dadurch wird die Fehlersuche erheblich vereinfacht und verkürzt, da binnen kurzer Zeit festgestellt werden kann, welches Bauteil des Signalübertragungspfades einen Fehler aufweist und wo in diesem Bauteil der Fehler örtlich vorhanden ist. Hierbei erfolgt die Bestimmung des Ortes der fehlerhaften Stelle auf einfache Weise mit geringem apparativem Aufwand und ohne aufwändige Rechenoperationen.

Eine besonders funktionssichere Kreuzkorrelation in Schritt (f) erzielt man dadurch, dass in Schritt (b) das zweite HF-Signal (18) mit einem mit einer vorbestimmten Modulationsart aufmodulierten Signal erzeugt wird, wobei optional das aufmodulierte Signal und die Modulationsart identisch zu Schritt (a) sind.

Das Verfahren ist apparativ besonders einfach und funktionssicher dadurch auszuführen, dass die Modulationsart eine Amplitudenmodulation (AM) oder eine digitale Modulation ist.

Eine mathematisch besonders einfache Bestimmung der Länge L erzielt man dadurch, dass in Schritt (g) die Länge L gemäß der Formel $L = \frac{1}{2} \cdot t_x \cdot c$ berechnet wird, wobei c eine Ausbreitungsgeschwindigkeit von HF-Signalen in dem Signalübertragungspfad ist.

Eine besonders einfaches, schnelles und funktionssicheres Verfahren erzielt man dadurch, dass in Schritt (f) das empfangene Intermodulations-Signal und das erzeugte Intermodulations-Signal in ihrer Phasenlage relativ zueinander solange gegeneinander verschoben werden, bis die aufmodulierten Signale deckungsgleich sind, wobei aus der erforderlichen Phasenverschiebung für die Deckungsgleichheit die Zeitdifferenz $t_x$ bestimmt wird.

Eine besonders genaue Ortsbestimmung bei einfachem technischem Aufbau erzielt man dadurch, dass in Schritt (c) das Intermodulationsprodukt dritter Ordnung IM3 mit der Frequenz $f_{IM3-ERZEUGT} = 2 \times f_1 - f_2$ oder $f_{IM3-ERZEUGT} = 2 \times f_2 - f_1$ erzeugt und in Schritt (e) das entsprechende Intermodulationsprodukt dritter Ordnung IM3 $f_{IM3-EMPFANGEN} = 2 \times f_1 - f_2$ oder $f_{IM3-EMRFANGEN} = 2 \times f_2 - f_1$ empfangen wird.

Eine Stelle, welche im Sinne von Hochfrequenzübertragungseigenschaften des Signalübertragungspfades fehlerhaft ist, umfasst wenigstens eine Stelle, an der eine Änderung, insbesondere ein Sprung, des HF-Wellenwiderstandes vorliegt, an der eine elektrische Kontaktierung fehlerhaft ist, insbesondere ein Kontaktwiderstand vorliegt, welcher größer als ein vorbestimmter Wert ist, und/oder an der eine nichtlineare Übertragungsfunktion für ein HF-Signal vorliegt.

In einer besonders bevorzugten Ausführungsform ist das aufmodulierte Signal ein Rauschen, insbesondere ein Quasirauschen oder Pseudo Noise.

Die Erfindung wird im Folgenden anhand der Zeichnung näher erläutert. Diese zeigt in:

Fig. 1     eine beispielhafte Ausführungsform des erfindungsgemäßen Verfahrens anhand eines schematischen Ablaufdiagramms und

Fig. 2     eine graphische Darstellung einer Signalauswertung gemäß dem erfindungsgemäßen Verfahren.

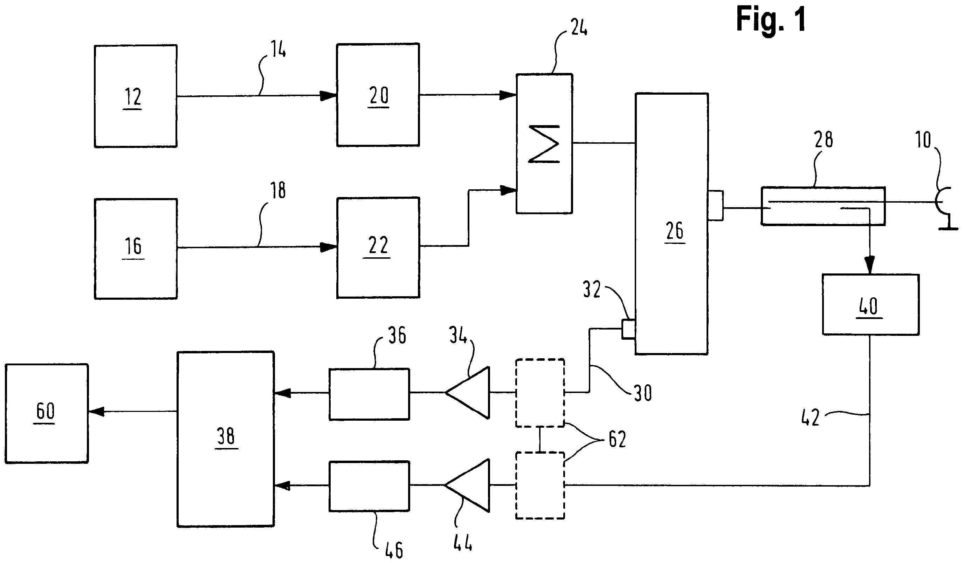

Die in Fig. 1 beispielhaft dargestellte, bevorzugte Ausführungsform des erfindungsgemäßen Verfahrens betrifft die Analyse eines Signalübertragungspfades (nicht dargestellt), welcher an einem Einleitungspunkt 10 elektrisch angeschlossen wird, hinsichtlich von Störstellen, welche die HF-Übertragungseigenschaften beeinträchtigen. Diese Störstellen verursachen eine nichtlineare Übertragungsfunktion hinsichtlich der Übertragung von HF-Signalen. Mit dem vorliegenden Verfahren wird ausgenutzt, dass derartige nichtlineare Übertragungsfunktionen zur Erzeugung von Intermodulationsprodukten führen, wenn zwei HF-Signale unterschiedlicher Frequenz gleichzeitig auf eine derartige Stelle mit nichtlinearer Übertragungsfunktion treffen. Diese Intermodulationsprodukte werden an diesen Stellen erzeugt und stellen keine Reflexion eines eingespeisten Signals, sondern ein neues, zuvor in dem Signalübertragungspfad nicht vorhandenes HF-Signal dar, welches hierin als Intermodulationssignal oder auch Intermodulationsprodukt bezeichnet wird.

In einem ersten Block 12 "$f_1$ mod." wird ein erstes HF-Signal 14 mit einer vorbestimmten, konstanten Frequenz $f_1$ erzeugt. Diesem ersten HF-Signal 14 wird ein Signal, insbesondere ein NF-Signal oder ein Rauschen aufmoduliert. Hierbei wird als Modulationsverfahren beispielsweise eine Amplitudenmodulation verwendet, es ist jedoch auch möglich eine digitale Modulation zu verwenden.

In einem zweiten Block 16 "$f_2$ mod." wird ein zweites HF-Signal 18 mit einer vorbestimmten, konstanten Frequenz $f_2$ erzeugt. Diesem zweiten HF-Signal 18 wird ebenfalls ein Signal, insbesondere ein NF-Signal oder Rauschen, mit einer vorbestimmen Modulationsart aufmoduliert, wobei das aufmodulierte Signal und die Modulationsart identisch zu dem aufmodulierten Signal und der Modulationsart wie bei dem ersten HF-Signal 14 gewählt werden. Auch die Phasenlage des aufmodulierten Signals ist für das erste HF-Signal 12 und das zweite HF-Signal 18 identisch. Das jeweils aufmodulierte Signal hat eine niedrigere Frequenz als die HF-Signale $f_1$ und $f_2$. Das aufmodulierte Signal ist beispielsweise ein niederfrequentes NF-Signal mit Frequenzanteilen im Bereich von 20 Hz bis 20 kHz. Das aufmodulierte Signal weist beispielsweise ein sich periodisch wiederholenden Signalverlauf auf.

In einem dritten Block "PA1" 20 wird das erste HF-Signal 12 und einem vierten Block "PA2" 22 wird das zweite HF-Signal 18 verstärkt. Nach der Verstärkung in den Blöcken 20 und 22 werden die beiden HF-Signale 12, 18 einem Combiner 24 zugeführt. Der Combiner 24 führt die auf eine Leitung kombinierten HF-Signale 12, 18 einem fünften Block 26 zu, der einen Duplexfilter enthält und das erste sowie zweite HF-Signal 12, 18 über einen Koppler 28 an dem Einleitungspunkt 10 in den Signalübertragungspfad einspeist. Diese beiden HF-Signale 12, 18 treffen nun auf ihrem Weg durch den Signalübertragungspfad ggf. auf eine Stelle mit nichtlinearer Übertragungsfunktion, beispielsweise einen defekten HF-Steckverbinder, eine schlechte Lötstelle oder einen Kabelbruch, so dass aus den beiden HF-Signalen 12, 18 an sich unerwünschte Intermodulationsprodukte, wie beispielsweise das Intermodulationsprodukt 3. Ordnung IM3, erzeugt werden. Diese Intermodulationsprodukte laufen als in dem Signalübertragungspfad erzeugte Signale bzw. Intermodulationsprodukte bzw. Intermodulationsproduktsignale zu dem Einleitungspunkt 10 zurück.

Mittels des fünften Blockes 26 wird gleichzeitig am Einleitungspunkt 10 ein in dem Signalübertragungspfad erzeugtes Signal empfangen und mittels des Duplexfilters das Intermodulationsprodukt 3. Ordnung IM3 30 mit einer Frequenz $f_{IM-EMPFANGEN}$ herausgefiltert und über einen Ausgang 32 ausgegeben. Dieses empfangene IM3 30 wird über einen Verstärker "LNA -low noise amplifier" 34 und einen A/D-Wandler 36 an einen sechsten Block 38 übergeben.

In dem Koppler 28 werden das eingespeiste erste und zweite HF-Signal 12, 18 ausgekoppelt und in einem siebten Block 40 "IM3 Ref" wird aus diesen beiden HF-Signalen 12, 18 das Intermodulationsprodukt 3. Ordnung IM3 42 mit der Frequenz $f_{IM-ERZEUGT}(t)$ erzeugt. Dieses erzeugte IM3 42 wird über einen Verstärker "LNA -low noise amplifier" 44 und einen A/D-Wandler 46 ebenfalls an den sechsten Block 38 übergeben.

Die Frequenz $f_{IM-ERZEUGT}$ des erzeugten Intermodulationsprodukts 3. Ordnung IM3 42 ergibt sich somit aus der Frequenz $f_1$ des ersten HF-Signals 12 und aus der Frequenz $f_2$ des zweiten HF-Signals 18 gemäß der Gleichung

$$f_{IM3-ERZEUGT} = 2 \times f_1 - f_2.$$

Das gleiche gilt für das empfangende Intermodulationsprodukt IM3 30. Beide Intermodulationsprodukte 30, 34 weisen zudem das aufmodulierte Signal auf. Allerdings liegen das empfangene IM3 30 und das erzeugte IM3 42 aufgrund von Laufzeitunterschieden zeitlich zueinander versetzt am Einleitungspunkt 10 vor, da das empfangene Intermodulationsprodukt IM3 30 zusätzlich einen Weg L vom Einleitungspunkt 10 zu der Stelle mit nichtlinearer Übertragungsfunktion sowie den Weg L wieder zurück von der Stelle mit nichtlinearer Übertragungsfunktion zum Einleitungspunkt 10 zurückgelegt hat.

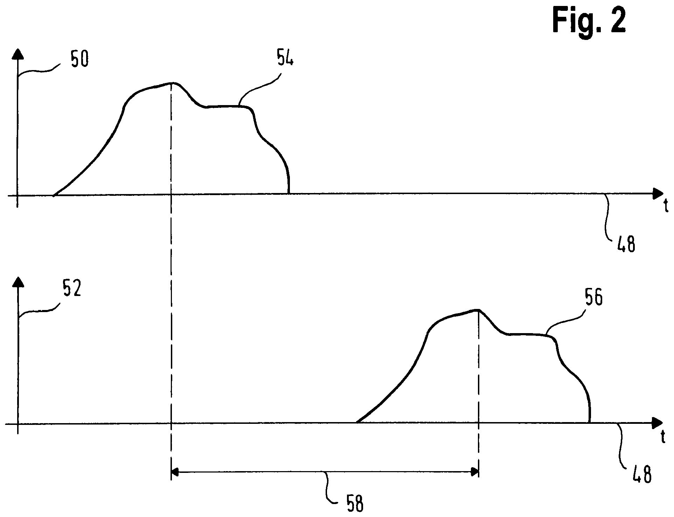

In dem Block 38, welcher beispielsweise als FPGA ("Field Programmable Gate Array) ausgebildet ist, werden das empfangene und erzeugte Intermodulationsprodukt 30 und 42 miteinander verglichen. Dies erfolgt mittels einer Kreuzkorrelation. Es wird ein Wert für eine Kreuzkorrelationsfunktion für das empfangene IM3 30 und das erzeugte IM3 42 für verschiedene Laufzeitunterschiede t bestimmt. Für einen Laufzeitunterschied $t_x$ weist diese Kreuzkorrelationsfunktion ein Maximum auf. Dieser Laufzeitunterschied $t_x$ entspricht dem Laufzeitunterschied für diese beiden IM3 30, 42. Dies ist in Fig. 2 dargestellt. Hier ist der zeitliche Verlauf des modulierten erzeugten IM3 42 und das empfangenen IM3 30 dargestellt. Auf einer jeweiligen x-Achse 48 ist hierbei die Zeit t, auf einer ersten y-Achse 50 ist eine Amplitude des erzeugten IM3 42 und auf einer zweiten y-Achse 52 ist eine Amplitude des empfangenen IM3 30 aufgetragen.

Ein erster Graph 54 veranschaulicht den zeitlichen Verlauf der Amplitude des erzeugten IM3 42 und ein zweiter Graph 56 veranschaulicht den zeitlichen Verlauf der Amplitude 52 des empfangen IM3 30. Die beiden Amplitudenverläufe sind identisch, da beide IM3 30, 42 phasengleich das identische aufmodulierte Signal aufweisen. Es liegt lediglich ein zeitlicher Abstand $t_x$ 58 zwischen den beiden IM3-Signalen 30, 42 vor.

Dies kann man nun für eine Auswertung mittels einer Kreuzkorrelation mit diesen beiden Signalen ausnutzen. Für verschiedene Zeitverschiebungen t als Parameter für die Kreuzkorrelationsfunktion ergibt sich für den Parameter $t = t_x$ ein Maximum der Kreuzkorrelationsfunktion. Mit anderen Worten werden mittels der Kreuzkorrelation die Amplitudenverläufe 54, 56 der beiden IM3-Signale 30, 42 solange gegen einander zeitlich, d.h. auf der Zeitachse 48, verschoben, bis die beiden Amplitudenverläufe 54, 56 deckungsgleich sind. Die hierfür erforderliche Verschiebung t entspricht genau der Laufzeitdifferenz $t_x$ zwischen den beiden IM3-Signalen 30, 42.

Aus diesem Laufzeitunterschied bzw. dieser Laufzeitdifferenz $t_x$ lässt sich auf einfache Weise die Länge L zwischen dem Einleitungspunkt 10 und der gesuchten fehlerhaften Stelle in dem Signalübertragungsweg bestimmen gemäß

$$L = \tfrac{1}{2} \cdot t_x \cdot c$$

bestimmen, wobei c eine Ausbreitungsgeschwindigkeit von HF-Signalen in dem Signalübertragungspfad ist. Diese Entfernung L ist die Strecke von dem Einleitungspunkt 10 bis zu einer Stelle, an der das Intermodulationsprodukt 3. Ordnung IM3 30 in dem Signalübertragungspfad aus dem ersten und zweiten HF-Signal 12, 18 erzeugt wurde.

Es muss nun nur noch diese Entfernung bzw. Länge L am Signalübertragungspfad 10 abgemessen werden und man erhält genau den Ort im Signalübertragungspfad 10 an dem sich ein Fehler mit nichtlinearer Übertragungsfunktion befindet, die die HF-Übertragungseigenschaften des Signalübertragungspfades 10 beeinträchtigt. Dies kann ein Bruch in einem HF-Kabel oder eine Fehlerstelle in der Antenne oder ein defekter HF-Steckverbinder oder eine fehlerhafte Lötstelle sein. Ggf. ist die elektrische Länge L in eine mechanische Länge umzurechnen. Es können selbstverständlich auch mehrere fehlerhafte Stellen gleichzeitig in dem Signalübertragungspfad vorhanden sein. In diesem Falle ergeben sich mehrere zeitlich versetzte, empfangene Intermodulationsprodukte IM3 30 die alle gleichzeitig ausgewertet werden können, so dass es mehrere Laufzeitdifferenzen $t_x$ und mehrere Längen L bestimmt werden können. Dadurch, dass als betrachtetes empfangenes Signal ein neu erzeugtes Intermodulationsprodukt verwendet wird, ist sichergestellt, dass die Länge L nur eine fehlerhafte Stelle mit nichtlinearer Übertragungsfunktion und keine sonstige Reflexion eines HF-Signals mit anderen Ursachen oder anderen Quellen betrifft.

Der Block 38 ist zur Steuerung und Datenausgabe mit einem Computer 60 verbunden.

Bei der in den Fig. 1 und 2 dargestellten, bevorzugten Ausführungsform des erfindungsgemäßen Verfahrens wird das Intermodulationsprodukt 3. Ordnung IM3 verwendet. Dies ist jedoch lediglich beispielhaft und es können auch andere Intermodulationsprodukte verwendet werden, wie beispielsweise das Intermodulationsprodukt 2. Ordnung ($2*f_1$, $2*f_2$, $f_1+f_2$, $f_2-f_1$), oder 4. Ordnung oder höher. Wichtig ist lediglich, dass das erzeugte Intermodulationsprodukt $f_{IM-ERZEUGT}(t)$ und das empfangene Intermodulationsprodukt $f_{IM-EMPFANGEN}(t)$ identisch sind und beide insbesondere phasengleich moduliert sind.

Zweckmäßigerweise wird eine Vorrichtung zum Ausführen des erfindungsgemäßen Verfahrens vor der ersten Messung kalibriert, um Laufzeiten der miteinander verglichenen HF-Signale 30 und 42 in der Auswerteelektronik vor dem Einleitungspunkt 10 außerhalb des Signalübertragungspfades zu eliminieren.

Optional sind Frequenzumsetzer (Down-Konverter) 62 für das erzeugte und das empfangene IM3 vorgesehen, die die jeweilige Frequenz dieser Signale auf eine für die LNAs 34, 44 und die A/D-Wandler 36, 46 geeignete Frequenz umsetzen.

Für das zweite HF-Signal 18 kann optional auf das aufmodulierte Signal auch verzichtet werden. In den ausgewerteten Intermodulationsprodukten 30 und 34 ist das aufmodulierte Signal bereits durch das erste HF-Signal 12 enthalten.

## Patentansprüche

1. Verfahren zum Orten von Stellen in einem Signalübertragungspfad für ein Hochfrequenzsignal, wobei diese Stellen im Sinne von Hochfrequenzübertragungseigenschaften des Signalübertragungspfades fehlerhaft sind, mit folgenden Schritten,

   (a) Erzeugen eines ersten HF-Signals (12) mit einer konstanten vorbestimmten Frequenz $f_1$ sowie einem mit einer vorbestimmten Modulationsart aufmodulierten Signal, wobei die Modulationsart eine Amplitudenmodulation oder eine digitale Modulation ist und/oder wobei das aufmodulierte Signal ein Rauschen ist, insbesondere ein Quasirauschen oder Pseudo-Noise;
   (b) Erzeugen eines zweiten HF-Signals (18) mit einer konstanten vorbestimmten Frequenz $f_2$;
   (c) Erzeugen eines vorbestimmten Intermodulationsproduktes in Form eines Intermodulationsprodukt-Signals (42) mit der Frequenz $f_{IM-ERZEUGT}$ aus dem ersten und dem zweiten HF-Signal (12, 18),
   (d) Einleiten des ersten HF-Signals (12) und des zweiten HF-Signals (18) in den Signalübertragungspfad an einem vorbestimmten Einleitungspunkt (10);
   (e) Empfangen eines in dem Signalübertragungspfad aus dem ersten HF-Signal (12) und dem zweiten HF-Signal (18) an einer fehlerhaften Stelle erzeugten und zum Einleitungspunkt (10) zurück reflektierten Intermodulationsproduktes, welches dem in Schritt (c) erzeugten Intermodulationsprodukt entspricht, in Form eines Intermodulationsprodukt-Signals (30) mit der Frequenz $f_{IM-EMPFANGEN}$, am vorbestimmten Einleitungspunkt (10);
   (f) Bestimmen einer Zeitverschiebung $t_x$ zwischen dem erzeugten Intermodulationsprodukt-Signal $f_{IM-ERZEUGT}$ (42) und dem empfangenen Intermodulationsprodukt-Signal $f_{IM-EMPFANGEN}$ (30) mittels einer Kreuzkorrelation und
   (g) Berechnen einer Länge L zwischen dem Einleitungspunkt (10) und der Stelle in dem Signalübertragungspfad, von der aus das in Schritt (e) empfangene Signal reflektiert wurde, aus der in Schritt (f) bestimmten Zeitverschiebung $t_x$.

2. Verfahren nach Anspruch 1, **dadurch gekennzeichnet, dass** in Schritt (b) das zweite HF-Signal (18) mit einem mit einer vorbestimmten Modulationsart aufmodulierten Signal erzeugt wird.

3. Verfahren nach Anspruch 2, **dadurch gekennzeichnet, dass** das aufmodulierte Signal und die Modulationsart identisch zu Schritt (a) sind.

4. Verfahren nach mindestens einem der vorhergehenden Ansprüche, **dadurch gekennzeichnet, dass** in Schritt (g) die Länge L gemäß der Formel

$$L = \tfrac{1}{2} \cdot t_x \cdot c$$

berechnet wird, wobei c eine Ausbreitungsgeschwindigkeit von HF-Signalen (12, 18, 30) in dem Signalübertragungspfad ist.

5. Verfahren nach mindestens einem der vorhergehenden Ansprüche, **dadurch gekennzeichnet, dass** in Schritt (f) das empfangene Intermodulations-Signal (30) und das erzeugte Intermodulations-Signal (42) in ihrer Phasenlage relativ zueinander solange gegeneinander verschoben werden, bis die aufmodulierten Signale (30, 42) deckungsgleich sind, wobei aus der erforderlichen Phasenverschiebung für die Deckungsgleichheit die Zeitdifferenz $t_x$ bestimmt wird.

6. Verfahren nach mindestens einem der vorhergehenden Ansprüche, **dadurch gekennzeichnet, dass** in Schritt (c) das Intermodulationsprodukt dritter Ordnung IM3 mit der Frequenz $f_{IM3-ERZEUGT} = 2 \times f_1 - f_2$ oder $f_{IM3-ERZEUGT} = 2 \times f_2 - f_1$ erzeugt und in Schritt (e) das entsprechende Intermodulationsprodukt dritter Ordnung IM3 $f_{IM3-EMPFANGEN}$ = 2 x $f_1$ - $f_2$ oder $f_{IM3-EMPFANGEN}$ = 2 x $f_2$ - $f_1$ empfangen wird.

7. Verfahren nach mindestens einem der vorhergehenden Ansprüche, **dadurch gekennzeichnet, dass** eine Stelle, welche im Sinne von Hochfrequenzübertragungseigenschaften des Signalübertragungspfades fehlerhaft ist, wenigstens eine Stelle umfasst, an der eine Änderung, insbesondere ein Sprung, des HF-Wellenwiderstandes vorliegt, an der eine elektrische Kontaktierung fehlerhaft ist, insbesondere ein Kontaktwiderstand vorliegt, welcher größer als ein vorbestimmter Wert ist, und/oder an der eine nichtlineare Übertragungsfunktion für ein HF-Signal vorliegt.

**Claims**

1. Method for locating points in a signal transmission path for a high frequency signal, said points being defective in terms of high frequency transmission characteristics of the signal transmission path, comprising the following steps,

   (a) Generation of a first HF signal (12) with a constant predetermined frequency $f_1$ and a signal modulated by means of a predetermined type of modulation, wherein the type of modulation is an amplitude modulation or a digital modulation and/or wherein the superimposed modulated signal is a noise, in particular a pseudo-noise;
   (b) Generation of a second HF signal (18) with a constant predetermined frequency $f_2$;
   (c) Generation of a predetermined iritermodulation product in the form of an intermodulation product signal (42) with the frequency $f_{IM-GENERATED}$ from the first and the second HF signal (12, 18),
   (d) Introduction of the first HF signal (12) and of the second HF signal (18) into the signal transmission path at a predetermined introduction point (10);
   (e) Reception, at the predetermined introduction point (10), of an intermodulation product which is generated in the signal transmission path from the first HF signal (12) and the second HF signal (18) at a defective point and reflected back to the introduction point (10) and which corresponds to the intermodulation product generated in step (c), in the form of an intermodulation product signal (30) having the frequency $f_{IM-RECEIVED}$;
   (f) Determination of a time lag $t_x$ between the generated intermodulation product signal $f_{IM-GENERATED}$ (42) and the received intermodulation product signal $f_{IM-RECEIVED}$ (30) by means of a cross-correlation and
   (g) Calculation of a length L between the introduction point (10) and the point in the signal transmission path from which the signal received in step (e) has been reflected, from the time lag $t_x$ determined in step (f).

2. Method according to claim 1, **characterised in that** in step (b) the second HF signal (18) is generated with a signal modulated with a predetermined type of modulation,

3. Method according to claim 2, **characterised in that** the modulated signal and the type of modulation are identical to step (a).

4. Method according to at least one of the preceding claims, **characterised in that** in step (g) the length L is calculated according to the formula

$$L = \tfrac{1}{2} * t_x * c,$$

   where c is a speed of propagation of HF signals (12, 18, 30) in the signal transmission path.

5. Method according to at least one of the preceding claims, **characterised in that** in step (f) the phase positions of the received intermodulation signal (30) and the generated intermodulation signal (42) are shifted relative to one another until the modulated signals (30, 42) are congruent, whereby the time difference $t_x$ is determined from the phase shift necessary in order to achieve congruence.

6. Method according to at least one of the preceding claims, **characterised in that** in step (c) the third-order intermodulation product IM3 is generated with the frequency $f_{IM3-GENERATED}$ = 2 x $f_1$ - $f_2$ or $f_{IM3-GENERATED}$ = 2 x $f_2$ - $f_1$ and the corresponding third-order intermodulation product IM3 $f_{IM3-RECEIVED}$ = 2 x $f_1$ - $f_2$ or $f_{IM3-RECEIVED}$ = 2 x $f_2$ - $f_1$ is received in step (e).

7. Method according to at least one of the preceding claims, **characterised in that** a point which is defective in terms of high frequency transmission characteristics of the signal transmission path comprises at least one point at which a change, in particular a sudden increase, in the HF characteristic impedance is present, at which an electrical contact is defective is, in particular at which a contact resistance is present which is greater than a predetermined value, and/or at which a non-linear transmission function for an HF signal is present.

## Revendications

1. Procédé de localisation d'emplacements dans un trajet de transmission de signal pour un signal radiofréquence, lesdits emplacements étant défectueux en termes de caractéristiques de transmission radiofréquence du trajet de transmission de signal, comprenant les étapes suivantes consistant à :

   (a) générer un premier signal RF (12) avec une fréquence prédéterminée constante $f_1$ et avec un signal modulé par un mode de modulation prédéterminé, le mode de modulation étant une modulation d'amplitude ou une modulation numérique et/ou le signal modulé étant un bruit, notamment un quasi-bruit ou pseudo-bruit ;
   (b) générer un second signal RF (18) avec une fréquence constante prédéterminée $f_2$;
   (c) générer un produit d'intermodulation prédéterminé sous la forme d'un signal de produit d'intermodulation (42) avec la fréquence $f_{\text{IM-générée}}$ à partir du premier et du second signal RF (12, 18),
   (d) injecter le premier signal RF (12) et le second signal RF (18) dans le trajet de transmission de signal à un point d'injection prédéterminé (10) ;
   (e) recevoir un produit d'intermodulation généré dans le trajet de transmission de signal à partir du premier signal RF (12) et du second signal RF (18) à un emplacement défectueux et réfléchi vers le point d'injection (10), produit qui correspond au produit d'intermodulation généré dans l'étape (c), sous la forme d'un signal de produit d'intermodulation (30) avec la fréquence $f_{\text{IM-reçue}}$ au point d'injection prédéterminé (10) ;
   (f) déterminer un décalage temporel tx entre le signal généré de produit d'intermodulation $f_{\text{IM-généré}}$ (42) et le signal reçu de produit d'intermodulation $f_{\text{IM-reçu}}$ (30) au moyen d'une corrélation croisée, et
   (g) calculer une longueur L entre le point d'injection (10) et l'emplacement dans le trajet de transmission de signal, à partir duquel le signal reçu dans l'étape (e) a été réfléchi, à partir du décalage temporel $t_x$ déterminé dans l'étape (f).

2. Procédé selon la revendication 1, **caractérisé en ce que** dans l'étape (b) le second signal RF (18) est généré avec un signal modulé par un mode de modulation prédéterminé.

3. Procédé selon la revendication 2, **caractérisé en ce que** le signal modulé et le mode de modulation sont identiques à ceux de l'étape (a).

4. Procédé selon l'une au moins des revendications précédentes, **caractérisé en ce que** dans l'étape (g) la longueur L est calculée selon la formule

$$L = \frac{1}{2} \cdot t_x \cdot c$$

où c est une vitesse de propagation de signaux RF (12, 18, 30) dans le trajet de transmission de signal.

5. Procédé selon l'une au moins des revendications précédentes, **caractérisé en ce que** dans l'étape (f), le signal d'intermodulation reçu (30) et le signal d'intermodulation généré (42) sont décalés l'un par rapport à l'autre dans leur position de phase l'un par rapport à l'autre jusqu'à ce que les signaux modulés (30, 42) soient coïncidants, la différence de temps $t_x$ étant déterminée par le déphasage requis pour la coïncidence.

6. Procédé selon l'une au moins des revendications précédentes, **caractérisé en ce que** dans l'étape (c), le produit d'intermodulation de troisième ordre IM3 est généré avec la fréquence $f_{\text{IM3-générée}} = 2 \times f_1 - f_2$ ou $f_{\text{IM3-générée}} = 2 \times f_2 - f_1$, et dans l'étape (e) le produit d'intermodulation correspondant de troisième ordre IM3 est reçu avec $f_{\text{IM3-reçue}} = 2 \times f_1 - f_2$ ou $f_{\text{IM3-reçue}} = 2 \times f_2 - f_1$.

7. Procédé de selon l'une au moins des revendications précédentes, **caractérisé en ce qu'**un emplacement défectueux en termes de caractéristiques de transmission radiofréquence du trajet de transmission de signal comprend au moins un emplacement auquel se présente une modification, en particulier un saut, de l'impédance caractéristique RF, auquel une mise en contact électrique est défectueuse, auquel se présente en particulier une résistance de contact qui est supérieure à une valeur prédéterminée, et/ou auquel se présente une fonction de transmission non-linéaire pour un signal RF.

**Fig. 1**

EP 2 926 152 B1

**Fig. 2**

EP 2 926 152 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010015102 A1
- WO 03027691 A1